# EUROPEAN PATENT APPLICATION

(11) **EP 3 026 660 A1**
(43) Date of publication of application: **01.06.2016**
(21) Application number: 15176891.8
(22) Date of filing: 15.07.2015
(51) Int. Cl.: G09G 3/20, H01L 27/32, G09G 3/32

(54) **METHOD OF PERFORMING A MULTI-TIME PROGRAMMABLE (MTP) OPERATION AND ORGANIC LIGHT-EMITTING DIODE (OLED) DISPLAY EMPLOYING THE SAME**

(30) Priority: 28.11.2014 KR 20140168228
(71) Applicant: Samsung Display Co., Ltd., Gyeonggi-do (KR)
(72) Inventor: SHIN, Dae-Yup, Gyeonggi-Do (KR); SHIM, Ji-Hye, Gyeonggi-Do (KR)
(74) Representative: Taor, Simon Edward William

(57) **Abstract**

A method of performing a multi-time programmable (MTP) operation and an organic light-emitting diode (OLED) display employing the same are disclosed. In one aspect, the method includes performing a white color MTP operation (S120) for displaying a first target color coordinate corresponding to a white color test grayscale on a display device so as to generate MTP adjustment data. The method also includes performing a blue color MTP operation (S140) for displaying a second target color coordinate corresponding to a blue color test grayscale on the display device. The blue color MTP operation includes adjusting the MTP adjustment data such that the display device displays blue color data using a blue color sub-pixel, a green color sub-pixel adjacent to the blue color sub-pixel, and a red color sub-pixel adjacent to the blue color sub-pixel (S160).

## Description

The described technology generally relates to a method of performing a multi-time programmable (MTP) operation, and an organic light-emitting diode (OLED) display employing the same.

An OLED includes an organic emission layer interposed between two electrodes, namely, an anode and a cathode. Positive holes received from the anode are combined with electrons received from the cathode in the organic emission layer to emit light. OLED displays have a variety of advantages over standard displays such as wide viewing angles, fast response speeds, thin profile, and low power consumption. Blue, green and red sub-pixels are formed together as a pixel. In manufacturing of displays, the color of light of each OLED will vary and blue LEDs, in particular, may need color correction to maintain display quality. One method of correction is to use a multi-time programmable operation.

One inventive aspect is a method of performing an MTP operation that can improve the efficiency of a blue color OLED.

Another aspect is an OLED display employing the method of performing the MTP operation.

Another aspect is a method of performing an MTP operation including an operation of performing a white color MTP operation for displaying a first target color coordinate corresponding to a white color test grayscale on a display device, and an operation of performing a blue color MTP operation for displaying a second target color coordinate corresponding to a blue color test grayscale on the display device. The blue color MTP operation can adjust MTP adjustment data to output blue color data using a blue color sub-pixel, a green color sub-pixel adjacent to the blue color sub-pixel, and a red color sub-pixel adjacent to the blue color sub-pixel.

In example embodiments, the MTP adjustment data can be adjusted to output the blue color data using a first red color sub-pixel, a first green color sub-pixel, and a first blue color sub-pixel that are included in a first pixel.

In example embodiments, performing the white color MTP operation can include an operation of determining the first target color coordinate corresponding to the white color test grayscale, an operation of measuring a first measured color coordinate for a first image corresponding to the white color test grayscale when the first image is displayed on the display device, an operation of comparing the first target color coordinate and the first measured color coordinate, and an operation of generating the MTP adjustment data such that the first measured color coordinate is reached to the first target color coordinate.

In example embodiments, performing the blue color MTP operation can include an operation of determining the second target color coordinate corresponding to the blue color test grayscale, an operation of measuring a second measured color coordinate for a second image corresponding to the blue color test grayscale when the second image is displayed on the display device, an operation of comparing the second target color coordinate and the second measured color coordinate, and an operation of adjusting the MTP adjustment data such that the second measured color coordinate is reached to the second target color coordinate.

In example embodiments, the MTP adjustment data can include MTP offset data that are calculated based on a reference gamma curve.

In example embodiments, the MTP offset data can include red color offset data corresponding to the red color sub-pixel, green color offset data corresponding to the green color sub-pixel, and blue color offset data corresponding to the blue color sub-pixel.

In example embodiments, the MTP adjustment data can be stored in a memory device that is included in a driving integrated circuit (IC).

Another aspect is an OLED display including a display panel including a plurality of pixels that include a red color sub-pixel, a green color sub-pixel, and a blue color sub-pixel that are adjacent to each other, a scan driver configured to provide scan signals to the pixels, a multi-time programmable (MTP) processor configured to adjust image data using MTP adjustment data for outputting blue color data using the blue color sub-pixel, the green color sub-pixel, and the red color sub-pixel, a data driver configured to generate data signals based on the adjusted image data, and configured to provide the data signals to the pixels, a power supply configured to provide a high power voltage and a low power voltage to the pixels, and a timing controller configured to control the scan driver, the MTP processor, the data driver, and the power supply.

In example embodiments, the MTP adjustment data can be adjusted by performing a white color MTP operation for displaying a first target color coordinate corresponding to a white color test grayscale on the display panel and performing a blue color MTP operation for displaying a second target color coordinate corresponding to a blue color test grayscale on the display panel.

In example embodiments, the MTP processor can include a memory configured to store the MTP adjustment data that are adjusted by the white color MTP operation and the blue color MTP operation and an image data adjustment unit configured to adjust the image data based on the MTP adjustment data stored in the memory.

In example embodiments, the MTP processor can be included in the data driver or the timing controller.

In example embodiments, the MTP adjustment data can include MTP offset data that are calculated based on a reference gamma curve.

In example embodiments, the MTP offset data can include red color offset data corresponding to the red color sub-pixel, green color offset data corresponding to the green color sub-pixel, and blue color offset data corresponding to the blue color sub-pixel.

In example embodiments, the pixels can be arranged in a stripe shape.

In example embodiments, the MTP processor can adjust the image data to output the blue color data using a first red color sub-pixel, a first green color sub-pixel, and a first blue color sub-pixel that are included in a first pixel.

In example embodiments, the pixels can be arranged in a pentile shape.

In example embodiments, the MTP processor can adjust the image data to output the blue color data using a second pixel and a third pixel. The second pixel can include a second blue color sub-pixel and a second green color sub-pixel. The third pixel can include a third red color sub-pixel and a third green color sub-pixel.

In example embodiments, a red color OLED included in the red color sub-pixel, a green color OLED included in the green color sub-pixel, and a blue color OLED included in the blue color sub-pixel can have different thicknesses from each other.

In example embodiments, the blue color OLED can include a first electrode, a second electrode opposing the first electrode, a blue color organic emission layer interposed between the first electrode and the second electrode, and a resonance layer interposed between the first electrode and the second electrode.

In example embodiments, the resonance layer can have a thickness for a constructive interference of a blue color light emitted by the blue color organic emission layer.

Another aspect is a method of performing a multi-time programmable (MTP) operation, the method comprising performing a white color MTP operation for displaying a first target color coordinate corresponding to a white color test grayscale on a display device so as to generate MTP adjustment data; and performing a blue color MTP operation for displaying a second target color coordinate corresponding to a blue color test grayscale on the display device, wherein the blue color MTP operation comprises adjusting the MTP adjustment data such that the display device displays blue color data using a blue color sub-pixel, a green color sub-pixel adjacent to the blue color sub-pixel, and a red color sub-pixel adjacent to the blue color sub-pixel.

In example embodiments, the blue, green, and red color sub-pixels are included in the same pixel. The performing of the white color MTP operation can include determining the first target color coordinate corresponding to the white color test grayscale; measuring a first color coordinate for a first image corresponding to the white color test grayscale when the first image is displayed on the display device; comparing the first target color coordinate to the first measured color coordinate; and generating the MTP adjustment data such that the first measured color coordinate substantially matches the first target color coordinate.

In example embodiments, performing the blue color MTP operation includes determining the second target color coordinate corresponding to the blue color test grayscale; measuring a second color coordinate for a second image corresponding to the blue color test grayscale when the second image is displayed on the display device; comparing the second target color coordinate to the second measured color coordinate; and adjusting the MTP adjustment data such that the second measured color coordinate substantially matches the second target color coordinate. The MTP adjustment data can include MTP offset data that are calculated based on a reference gamma curve.

In example embodiments, the MTP offset data include red color offset data corresponding to the red color sub-pixel, green color offset data corresponding to the green color sub-pixel, and blue color offset data corresponding to the blue color sub-pixel. The display device can comprise a driving integrated circuit (IC) including a memory and the MTP adjustment data can be stored in the memory.

Another aspect is an OLED display comprising a display panel including a plurality of pixels, wherein the pixels include a red color sub-pixel, a green color sub-pixel, and a blue color sub-pixel that are adjacent to each other; a scan driver configured to apply scan signals to the pixels; a multi-time programmable (MTP) processor configured to adjust image data using MTP adjustment data, wherein the display panel is configured to display blue color data using the blue color sub-pixel, the green color sub-pixel, and the red color sub-pixel; a data driver configured to: i) generate data signals based on the adjusted image data and ii) apply the data signals to the pixels; a power supply configured to provide a high power voltage and a low power voltage to the pixels; and a timing controller configured to control the scan driver, the MTP processor, the data driver, and the power supply.

In example embodiments, the MTP processor is further configured to adjust the MTP adjustment data via performing a white color MTP operation for displaying a first target color coordinate corresponding to a white color test grayscale on the display panel; and performing a blue color MTP operation for displaying a second target color coordinate corresponding to a blue color test grayscale on the display panel. The MTP processor can include a memory configured to store the MTP adjustment data, wherein the MTP processor is further configured to adjust the MTP adjustment data based on the white color MTP operation and the blue color MTP operation; and an image data adjustment unit configured to adjust the image data based on the MTP adjustment data.

In example embodiments, the MTP processor is included in the data driver or the timing controller. The MTP adjustment data can include MTP offset data that are calculated based on a reference gamma curve. The MTP offset data can include red color offset data corresponding to the red color sub-pixel, green color offset data corresponding to the green color sub-pixel, and blue color offset data corresponding to the blue color sub-pixel. The pixels can be arranged in a stripe shape. The MTP processor can be further configured to adjust the image data such that the display panel displays the blue color data using a first red color sub-pixel, a first green color sub-pixel, and a first blue color sub-pixel that are included in a first pixel. The pixels can be arranged in a pentile shape.

In example embodiments, the MTP processor is further configured to adjust the image data such that the display panel display the blue color data using a second pixel and a third pixel, the second pixel includes a second blue color sub-pixel and a second green color sub-pixel, and the third pixel includes a third red color sub-pixel and a third green color sub-pixel. The red, green, and blue color sub-pixels can respectively comprise red, green, and blue organic light-emitting diodes (OLEDs) and each of the red, green, and blue OLEDs can have a different thickness.

In example embodiments, the blue color OLED comprises a first electrode; a second electrode opposing the first electrode; a blue color organic emission layer interposed between the first electrode and the second electrode; and a resonance layer interposed between the first electrode and the second electrode. The resonance layer can have a thickness selected such that the blue color light emitted by the blue color organic emission layer constructively interferes.

Therefore, a method of performing an MTP operation according to example embodiments performs a white color MTP operation and a blue color MTP operation. The method of performing the MTP operation improves an efficiency of a blue color OLED by outputting blue color data using a blue color sub-pixel, a green color sub-pixel, and a red color sub-pixel that are adjacent to each other.

According to an aspect of the invention, there is provided a method of performing a multi-time programmable, MTP, operation as set out in claim 1. Preferred features of this aspect are set out in claims 2 to 7.

According to an aspect of the invention, there is provided an organic light-emitting diode, OLED, display as set out in claim 8. Preferred features of this aspect are set out in claims 9 to 15.

According to at least one embodiment, an OLED display employs the method of performing the MTP operation. Therefore, the OLED display can have an improved life span and reduced power consumption.

### Brief Description of the Drawings

FIG. 1 is a flowchart illustrating a method of performing an MTP operation according to example embodiments.
FIG. 2 is a cross-sectional view illustrating an example of a display panel.
FIG. 3 is a cross-sectional view illustrating an example of a blue color OLED included in the display panel of FIG. 2.
FIGS. 4 and 5 are graphs illustrating examples of the efficiency of a blue color OLED according to the thickness of the blue color OLED.
FIG. 6 is a flowchart illustrating an example of performing a white color MTP operation in the method of FIG. 1.
FIG. 7 is a flowchart illustrating an example of performing a blue color MTP operation in the method of FIG. 1.
FIGS. 8 through 10 are diagrams illustrating examples of outputting blue color data using MTP adjustment data that are adjusted by the method of FIG. 1.
FIG. 11 is a block diagram illustrating an OLED display according to example embodiments.
FIG. 12 is a block diagram illustrating an example of an MTP processor included in the OLED display of FIG. 11.

During the manufacturing of an OLED display, the image quality of the end product (i.e., the complete product) may not reach a target quality level due to manufacturing errors. Thus, the end product may be defective and discarded. However, discarding all defective end products reduces the manufacturing yield. Yield can be improved via post-manufacturing correction that includes adjusting the image quality of the OLED display to reach the target quality level. This can include a multi-time programmable operation in which post-manufacturing correction of luminance and color coordinates for respective pixels is repeatedly performed such that the OLED display reaches the target quality level.

OLEDs can include a resonance structure which improves their efficiency. However, the standard OLED display employing such a resonance structure has a relatively low emission efficiency since only a portion of the spectrum of emitted light is used to reach a target color coordinate for each pixel. Especially, blue color OLEDs lose a relatively large portion of the emitted spectrum to reach the target color coordinate. Therefore, they have a relatively low light efficiency compared to red and green color OLEDs.

Exemplary embodiments will be described more fully hereinafter with reference to the accompanying drawings, in which various embodiments are shown.

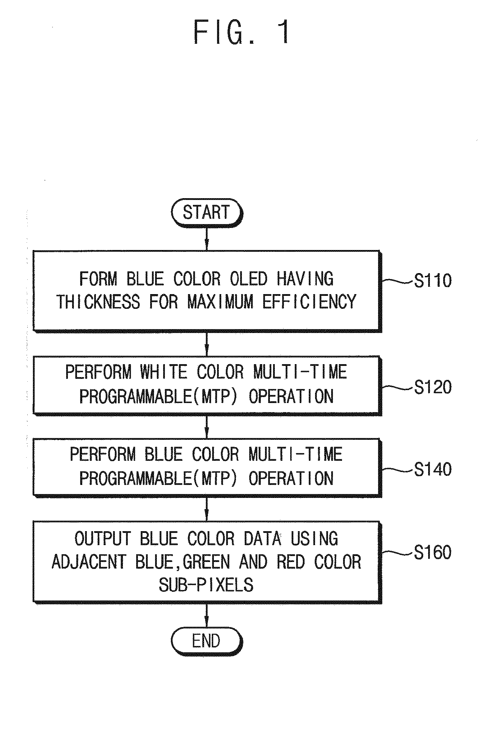

FIG. 1 is a flowchart illustrating a method of performing an MTP operation according to example embodiments.

Referring to FIG. 1, the method of performing the MTP operation can adjust MTP adjustment data by performing a white color MTP operation and a blue color MTP operation. Blue color data can be output using a blue color sub-pixel, a green color sub-pixel, and a red color sub-pixel that are adjacent to each other, thereby improving the efficiency of a blue color OLED.

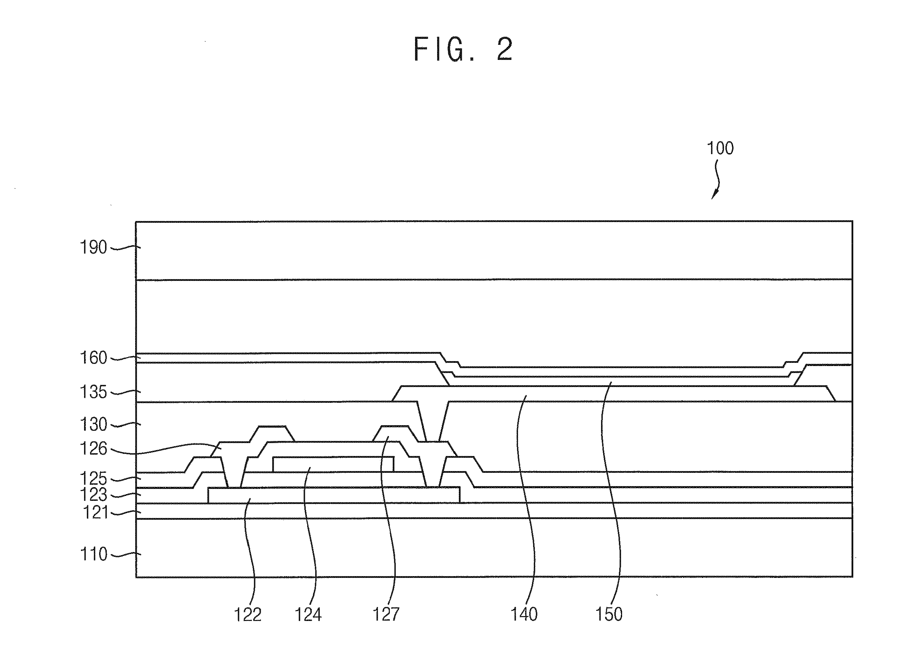

The blue color OLED is formed such that the blue color OLED has a thickness for maximum or increased efficiency (Step S110). Generally, blue color OLEDs have a resonance structure which has low light efficiency because only a portion of spectrum of emitted light is used to reach a target color coordinate. Therefore, to improve the efficiency of the blue color OLED, the blue color OLED can be formed to have a thickness for maximum efficiency. Here, the blue color coordinate can be set using a red color OLED and a green color OLED as well as the blue color OLED. Thus, blue color light can be emitted using the red color OLED and the green color OLED that have a high light efficiency in addition to the blue color OLED which has a thickness formed to have maximum efficiency. Hereinafter, the structure of the blue color OLED and a method of adjusting the thickness of the blue color OLED will be described in detail with reference to FIGS. 2 through 5.

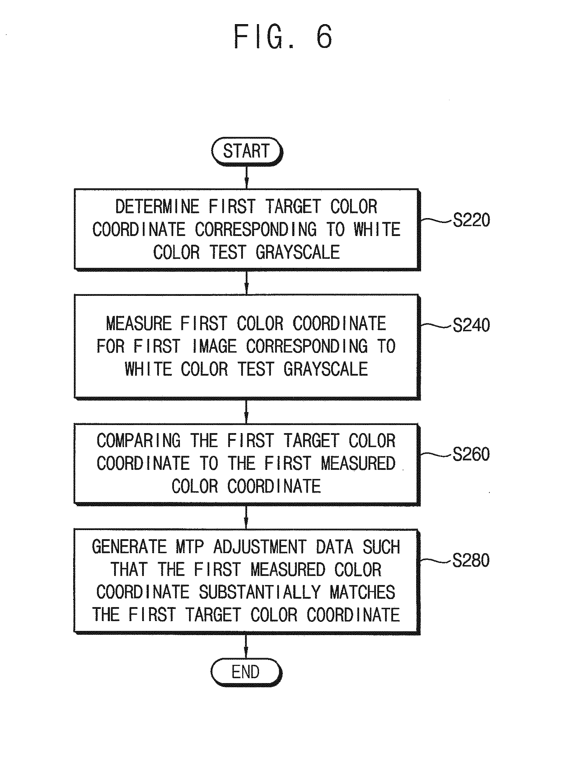

A white color MTP operation is performed such that a display device displays a first target color coordinate corresponding to a white color test grayscale (Step S120). The white color MTP operation can be repeatedly performed for the correction of the luminance and color coordinates for respective pixels to reach the target quality level of the display device. Thus, the white color MTP operation can measure a first measured color coordinate when the display device displays a first image corresponding to the white color test grayscale. The white color MTP operation can compare the first target color coordinate and the first measured color coordinate to generate the MTP adjustment data. A method of performing a white color MTP operation will be described in detail below with reference to the FIG. 6.

The blue color MTP operation is performed such that a display device displays a second target color coordinate corresponding to a blue color test grayscale (Step S140). Since the blue color OLED is formed such that the blue color OLED has a thickness for maximum or increased efficiency, the blue color MTP operation can be performed to reach the second target color coordinate.

The blue color MTP operation can be performed to improve the efficiency of the display device. The blue color MTP operation can measure a second measured color coordinate when the display device displays a second image corresponding to the blue color test grayscale. The blue color MTP operation can compare the second target color coordinate and the second measured color coordinate to set the MTP adjustment data. Therefore, the blue color light can be emitted using the red color OLED and the green color OLED as well as the blue color OLED.

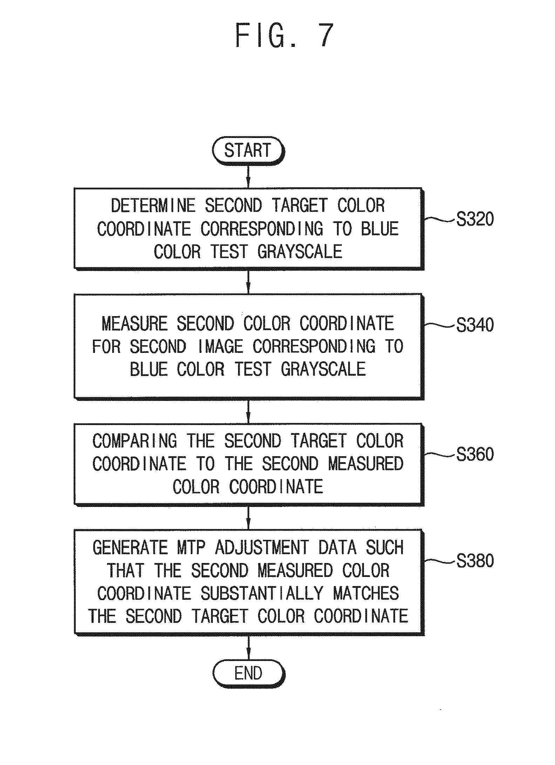

In one example embodiment, the MTP adjustment data can include MTP offset data that are calculated based on a reference gamma curve. For example, the reference gamma curve can be stored in a register in driving integrated circuit (IC). The MTP offset data can be calculated as the difference between the reference gamma curve and compensation data in the white color MTP operation and the blue color MTP operation. A deviation in the display characteristics of the display device can be efficiently reduced using the MTP offset. In one example embodiment, the MTP offset data can include red color offset data corresponding to the red color sub-pixel, green color offset data corresponding to the green color sub-pixel, and blue color offset data corresponding to the blue color sub-pixel. Thus, the offset data for each pixel can be respectively stored to independently set gamma curves for each pixel, thereby enhancing the display quality. In one example embodiment, the MTP adjustment data can be stored in a memory device or memory that is included in a driving IC. A method of performing the blue color MTP operation will be described in detail below with reference to FIG. 7.

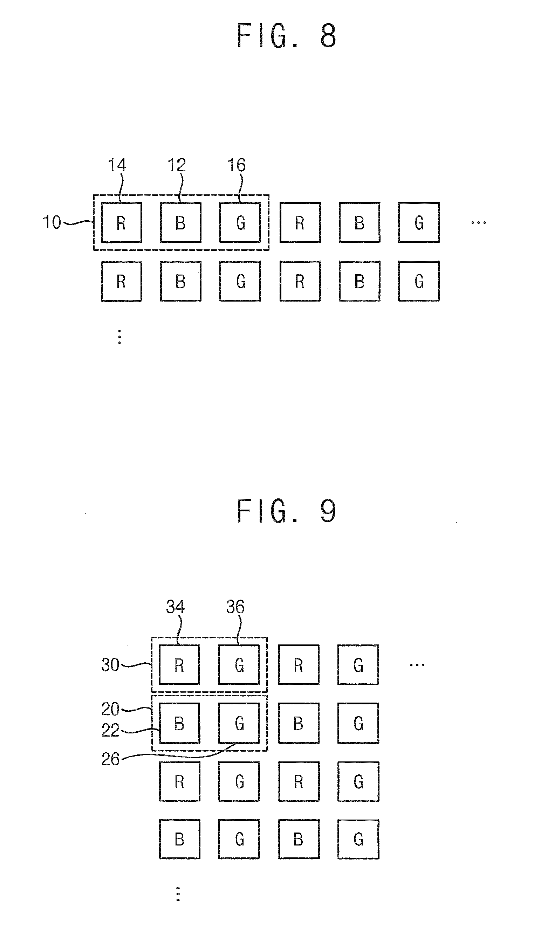

The blue color data is output using a set of adjacent blue, green and red color sub-pixels (Step S160). The OLED display can adjust the input data using the MTP adjustment data stored in the memory device. Here, the OLED display outputs the blue color data using the green and red color sub-pixels adjacent to each other to improve the blue color OLED. In one example embodiment, the blue color data is output using a first red color sub-pixel, a first green color sub-pixel, and a first blue color sub-pixel that are included in a first pixel. Thus, the blue color light can be emitted using the blue, red, and green color sub-pixels that are included in the same pixel. In another example embodiment, the blue color data is output using the blue, red, and green color sub-pixels that are adjacent to each other. Hereinafter, examples of outputting the blue color data using the MTP adjustment data will be described in detail with reference to FIGS. 8 through 10.

Although the example embodiments of FIG. 1 describe that the MTP adjustment data include MTP offset data, the MTP adjustment data can include a variety of information for adjusting the reference gamma curve. For example, the MTP adjustment data can include information for the compensation gamma curve.

FIG. 2 is a cross-sectional view illustrating an example of a display panel.

Referring to FIG. 2, the display panel 100 includes a first substrate 110, a thin film transistor, an OLED, and a second substrate 190.

One of the first substrate 110 or the second substrate 190 is a base substrate and the other of the first substrate 110 or the second substrate 190 is an encapsulation substrate. The second substrate 190 can be formed opposite to the first substrate 110. The first substrate 110 or the second substrate 190 can include a transparent insulation substrate. For example, the first substrate 110 or the second substrate 190 can include a glass substrate, a quartz substrate, or a transparent resin substrate, etc. The transparent resin substrate can include polyamide resin, acryl resin, polyacrylate resin, polycarbonate resin, polyether resin, polyethylene terephthalate resin, or sulfonic acid resin, etc.

The thin film transistor includes a buffer layer 121, an active layer 122, a gate insulation layer 123, a gate electrode 124, an inorganic insulation layer 125, a source electrode 126, and a drain electrode 127.

The buffer layer 121 is formed on the first substrate 110. The buffer layer 121 can prevent the diffusion of metal atoms and/or impurities from the first substrate 110. In addition, the buffer layer 121 can improve the flatness of the surface of the first substrate 110. The active layer 122 may include amorphous silicon, poly silicon and/or organic semiconductor materials. The gate insulation layer 123 is formed on the active layer 122. The gate insulation layer 123 can entirely cover the active layer 122. The gate electrode 124 is formed on the gate insulation layer 123 and overlaps the active layer 122. The inorganic insulation layer 125 is formed on the gate electrode 124 and can entirely cover the gate electrode 124. The source electrode 126 is electrically connected to the active layer 122 through a first contact hole that is formed in the gate insulation layer 123 and the inorganic insulation layer 125. For example, the source electrode 126 contacts a first end portion of the active layer 122. In addition, the source electrode 126 can partially overlap the first end portion of the gate electrode 124. The drain electrode 127 is electrically connected to the active layer 122 through a second contact hole that is formed in the gate insulation layer 123 and the inorganic insulation layer 125. For example, the drain electrode 127 contacts a second end portion of the active layer 122. In addition, the drain electrode 127 can partially overlap the second end portion of the gate electrode 124.

The organic insulation layer 130 is formed on the inorganic insulation layer 125 on which the source electrode 126 and the drain electrode 127 are formed.

The OLED includes a first electrode 140, a middle layer 150, and a second electrode 160.

The first electrode 140 is formed on the organic insulation layer 130. The first electrode 140 is electrically connected to the drain electrode 127. In one example embodiment, the first electrode 140 is used as an anode electrode that provides positive holes to the middle layer 150.

The middle layer 150 is formed on the first electrode 140. The middle layer 150 can include an organic emission layer. The organic emission layer may sequentially include a hole injection layer, a hole transfer layer, an emission layer, an electron transfer layer, and an electron injection layer. The first electrode 140 can provide positive holes to the hole injection layer and the hole transfer layer. The second electrode 160 can provide electrons to the electron transfer layer and the electron injection layer. The positive holes can be combined with the electrons in the emission layer to generate light having a desired wavelength.

The second electrode 160 is formed on the middle layer 150. In one example embodiment, the second electrode 160 is used as a cathode that provides electrons to the middle layer 150.

In one example embodiment, a red color OLED included in a red color sub-pixel, a green color OLED included in a green color sub-pixel, and a blue color OLED included in a blue color sub-pixel have different thicknesses from each other. Thus, the red, green, and blue color OLEDs may have different thicknesses from each other to respectively achieve optimal efficiency. In one example embodiment, in the blue color OLED, the middle layer 150 further includes a resonance layer. Thus, the blue color OLED can be formed such that the blue color OLED has a thickness for maximum efficiency by including the resonance layer to achieve resonance, thereby improving the efficiency of the blue color OLED.

The pixel defining layer 135 is formed on the organic insulation layer 130 on which the pixel electrode 140 is formed. The pixel defining layer 135 partially overlaps two end portions of the pixel electrode 140. The pixel defining layer 135 overlaps the common electrode 160.

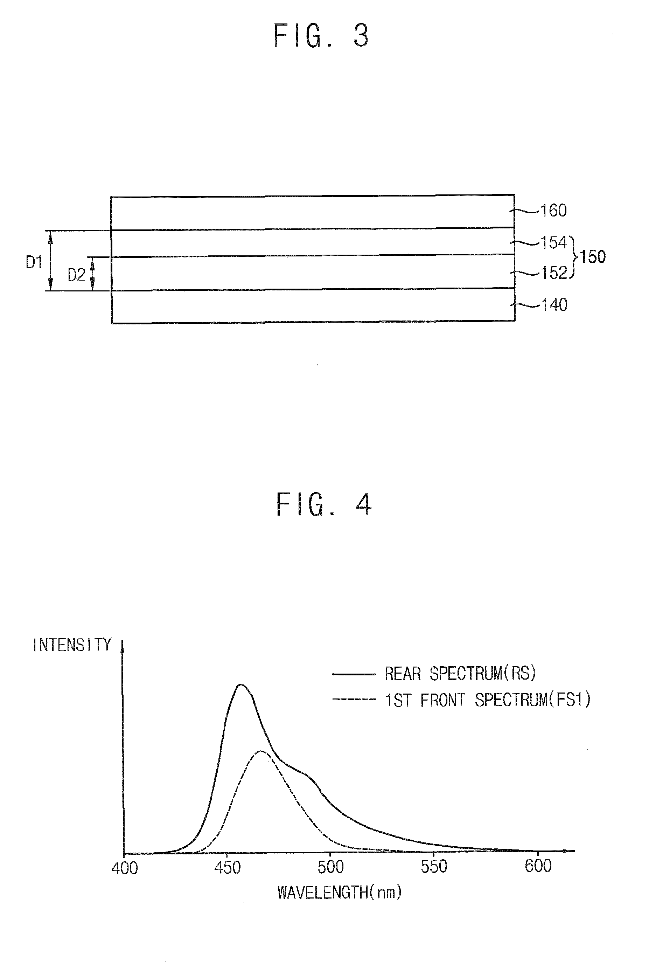

FIG. 3 is a cross-sectional view illustrating an example of a blue color OLED included in the display panel of FIG. 2.

Referring to FIG. 3, the blue color OLED includes a first electrode 140, a resonance layer 152, an organic emission layer 154, and a second electrode 160.

The first electrode 140 can be used as an anode electrode that provides positive holes to the middle layer 150.

The resonance layer 152 is interposed between the first electrode 140 and the second electrode 160. The resonance layer 152 can have a thickness D2 that is specified to increase the efficiency of the blue color OLED by resonance. In one example embodiment, the resonance layer 152 has the thickness D2 which enables constructive interference of light emitted by the organic emission layer 154. Thus, the resonance layer 152 can adjust a distance D1 between the first electrode 140 and the second electrode 160 to efficiently induce constructive interference of the light emitted by the organic emission layer 154.

The organic emission layer 154 is interposed between the first electrode 140 and the second electrode 160. The organic emission layer 154 may sequentially include a hole injection layer, a hole transfer layer, an emission layer, an electron transfer layer, and an electron injection layer. Positive holes from the anode are combined with electrons from the cathode in the organic emission layer 154 between the anode and the cathode to emit light.

The second electrode 160 is formed opposite to the first electrode 140. The second electrode 160 can be used as a cathode that provides electrons to the middle layer 150.

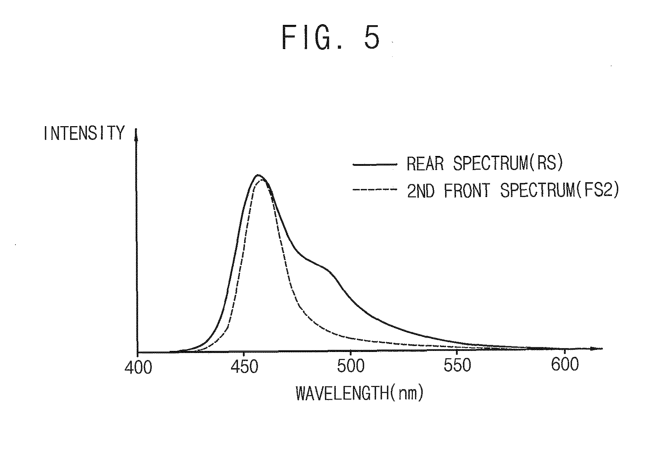

FIGS. 4 and 5 are graphs illustrating examples of the efficiency of a blue color OLED according to the thickness of the blue color OLED.

Referring to FIGS. 4 and 5, to improve the efficiency of the blue color OLED, the thickness of the blue color OLED can be adjusted considering the resonance of the blue color OLED.

As shown in FIG. 4, the standard OLED display may have low light efficiency because only a portion of the spectrum of light emitted is used to reach a target color coordinate for each pixel that has a resonance structure. Especially, the blue color OLED may lose a relatively large portion of its spectrum to reach the target color coordinate in comparison with the red color OLED or the green color OLED. A first front spectrum FS1 of the blue color light can be affected by the resonance of the blue color OLED. On the other hand, a rear spectrum RS of the blue color light may not affected by the resonance of the blue color OLED. When the thickness of the blue color OLED is adjusted to reach the target color coordinate, the first front spectrum FS1 may lose a relatively large portion of its spectrum in contrast with the rear spectrum RS. Therefore, the standard blue color OLED may have a relatively low efficiency, thereby decreasing its life span and increasing power consumption.

As shown in FIG. 5, the thickness of the blue color OLED can be adjusted such that constructive interference of the light occurs efficiently, thereby improving the efficiency of the blue color OLED. A blue color MTP operation can be performed after the thickness of the blue color OLED is adjusted. A second front spectrum FS2 of the blue color light can be affected by the resonance of the blue color OLED. In this embodiment, the loss of portions of the spectrum of the second front spectrum FS2 can be minimized. Therefore, the blue color OLED can have a relatively high efficiency, thereby increasing its life span and reducing power consumption.

FIG. 6 is a flowchart illustrating an example of performing a white color MTP operation in the method of FIG. 1.

Referring to FIG. 6, the white color MTP operation can include repeatedly performing the correction in a color coordinate for each pixel to reach a target quality level of a display device.

A first target color coordinate corresponding to a white color test grayscale is determined (Step S220). Here, the first target color coordinate is a target color coordinate to be displayed when the display device displays the first image corresponding to the white color test grayscale.

When the first image corresponding to the white color test grayscale is displayed on the display device, a first color coordinate for the first image is measured (Step S240). For example, the display device can display the first image and the first color coordinate for the first image can be measured using optical devices.

The first target color coordinate and the first measured color coordinate are compared (Step S260). The MTP adjustment data is generated such that the first measured color coordinate substantially matches the first target color coordinate (Step S280). When the first target color coordinate is substantially equal to the first measured color coordinate, the correction does not need to be performed. On the other hand, when the first target color coordinate is different from the first measured color coordinate, deviation in the display characteristics of pixels can occur. The MTP adjustment data may be generated such that the first measured color coordinate substantially matches the first target color coordinate, thereby enhancing the display quality.

FIG. 7 is a flowchart illustrating an example of performing a blue color MTP operation in the method of FIG. 1.

Referring to FIG. 7, the blue color OLED is formed such that blue color OLED has a thickness for maximum or increased efficiency and the blue color MTP operation corresponding to blue color coordinate can be performed.

A second target color coordinate corresponding to a blue color test grayscale is determined (Step S320). Here, the second target color coordinate is a target color coordinate to be displayed when the display device displays the second image corresponding to the blue color test grayscale.

When the second image corresponding to the blue color test grayscale is displayed on the display device, a second color coordinate for the second image is measured (Step S340). For example, the display device can display the second image and the second color coordinate for the second image can be measured using the optical devices.

The second target color coordinate and the second measured color coordinate are compared (Step S360). The MTP adjustment data is adjusted such that the second measured color coordinate substantially matches the second target color coordinate (Step S380). When the blue color OLED is formed to have a thickness for the maximum or increased efficiency without considering the color coordinate for the blue color, the second measured color coordinate may be different from the second target color coordinate. Therefore, the MTP adjustment data can be adjusted such that the second measured color coordinate substantially matches the second target color coordinate, thereby correcting the color coordinate for the blue color.

In one example embodiment, the MTP adjustment data includes MTP offset data that are calculated based on a reference gamma curve. The reference gamma curve can be stored in a register in driving IC. The MTP offset data can be calculated by the white color MTP operation and the blue color MTP operation. If the MTP adjustment data includes compensation gamma curves for each of the pixels, a high-capacity memory device may be needed to store the MTP adjustment data. On the other hand, when the MTP adjustment data includes the MTP offset data, a difference between the reference gamma curve and compensation data can be stored in the register or the memory device. Therefore, the amount of MTP adjustment data can be reduced and a deviation in the display characteristics of the display device can be efficiently reduced. In one example embodiment, the MTP offset data includes red color offset data corresponding to the red color sub-pixel, green color offset data corresponding to the green color sub-pixel, and blue color offset data corresponding to the blue color sub-pixel. Thus, the offset data for each pixel can be respectively stored to independently set gamma curves for each pixel, thereby enhancing the display quality. The MTP adjustment data can be stored in the memory device that is included in the driving IC. For example, the MTP adjustment data can be stored in the memory device included in the MTP processor and the image data can be adjusted using the MTP adjustment data. Therefore, the blue color data can be output using a blue color sub-pixel, a green color sub-pixel, and a red color sub-pixel that are adjacent to each other.

FIGS. 8 through 10 are diagrams illustrating examples of outputting blue color data using MTP adjustment data that are adjusted by the method of FIG. 1.

Referring to FIGS. 8 through 10, image data can be adjusted using MTP adjustment data to output blue color data using a blue color sub-pixel, a green color sub-pixel, and a red color sub-pixel that are adjacent to each other. Thus, a blue color light can be emitted using the red color OLED and the green color OLED that have a relatively high light efficiency as well as the blue color OLED that has a relatively low light efficiency. Therefore, efficiency of the OLED display can be improved.

As shown in FIG. 8, pixels can be arranged in a stripe shape. Each pixel can have at least three sub-pixels. For example, the display panel can include a first column including red color OLEDs, a second column including blue color OLEDs, and a third column including green color OLEDs. In one example embodiment, the MTP adjustment data are adjusted to output the blue color data using a first red color sub-pixel 14, a first green color sub-pixel 16, and a first blue color sub-pixel 12 that are included in a first pixel 10. Thus, the blue color light can be emitted using the blue, red, and green color OLEDs that are included in the same pixel. For example, the blue color data for the first pixel 10 can be output using the first red color sub-pixel 14 and the first green color sub-pixel 16 included in the first pixel 10 as well as the first blue color sub-pixel 12.

As shown in FIG. 9, the pixels can be arranged in a pentile shape. Each pixel can have two sub-pixels. For example, the display panel can include a first column in which the blue color OLEDs and the red color OLEDs are alternately formed and a second column in which the green color OLEDs are formed. In one example embodiment, the MTP adjustment data are adjusted to output the blue color data using a second pixel 20 and a third pixel 30 that are adjacent to each other. Here, the second pixel 20 includes a second blue color sub-pixel 22 and a second green color sub-pixel 26. The third pixel 30 includes a third red color sub-pixel 34 and a third green color sub-pixel 36. Thus, the blue color light can be emitted using the blue, red, and green color OLEDs that are included in the same pixel or adjacent pixel. For example, the blue color data for the second pixel 20 can be output using the second green color sub-pixel 26 included in the second pixel 20, the third red color sub-pixel 34 and the third green color sub-pixel 36 included in the third pixel 30 as well as the second blue color sub-pixel 22.

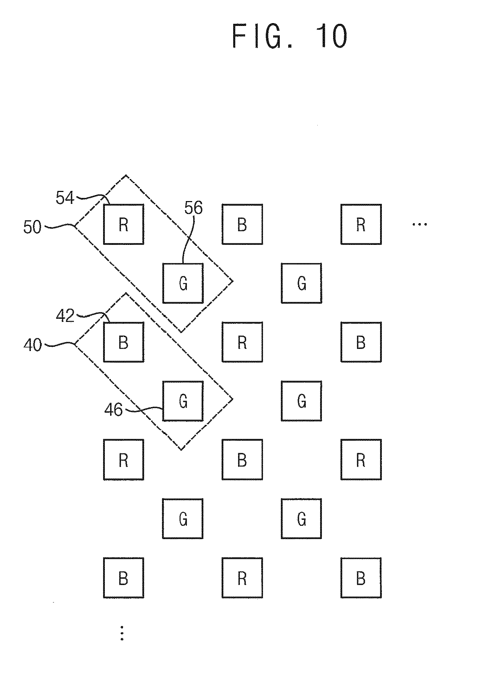

As shown in FIG. 10, the pixels can be arranged in a diamond pentile shape. Each pixel has two sub-pixels and the sub-pixels are arranged in diagonal. When the sub-pixels are diagonally arranged, the OLEDs are arranged in a diamond shape for the efficient use of space and to improve display quality. In one example embodiment, the MTP adjustment data are adjusted to output the blue color data using a second pixel 40 and a third pixel 50 that are adjacent to each other. Here, the second pixel 40 includes a second blue color sub-pixel 42 and a second green color sub-pixel 46. The third pixel 50 includes a third red color sub-pixel 54 and a third green color sub-pixel 56. Thus, the blue color light can be emitted using the blue, red, and green color OLEDs that are included in the same pixel or adjacent pixel. For example, the blue color data for the second pixel 40 can be output using the second green color sub-pixel 46 included in the second pixel 40, the third red color sub-pixel 54 and the third green color sub-pixel 56 included in the third pixel 50 as well as the second blue color sub-pixel 42.

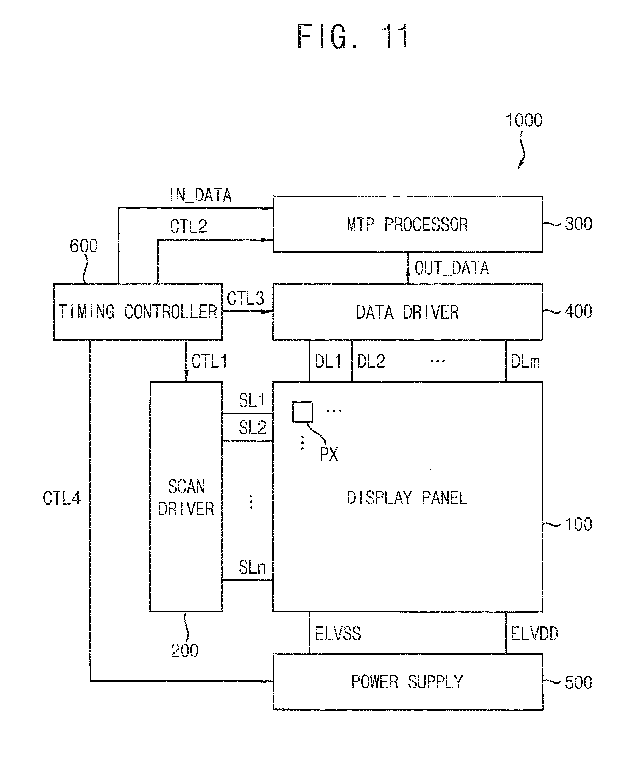

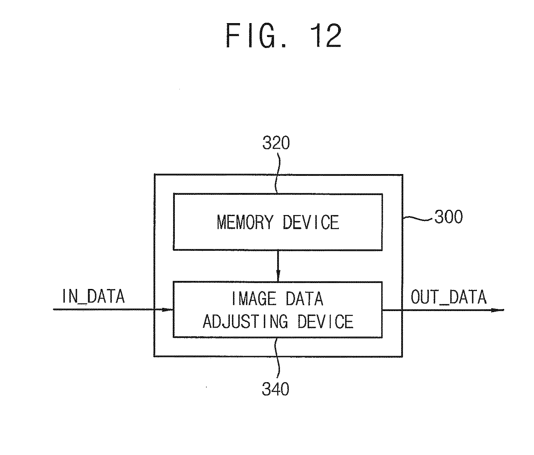

FIG. 11 is a block diagram illustrating an OLED display according to example embodiments. FIG. 12 is a block diagram illustrating an example of an MTP processor included in the OLED display of FIG. 11.

Referring to FIGS. 11 and 12, the OLED display 1000 can display an image with high quality and improve the efficiency of a blue color OLED by including an MTP processor 300.

As shown in FIG. 11, the OLED display device 1000 includes a display panel 100, a scan driver 200, an MTP processor 300, a data driver 400, a power supply 500, and a timing controller 600.

The display panel 100 includes a plurality of pixels PX. The display panel 100 is connected to the scan driver 200 via a plurality of scan lines SL1 through SLn. The display panel 100 is connected to the data driver 400 via a plurality of data lines DL1 through DLn. The display panel 100 includes n*m pixels PX since the pixels PX are arranged at locations corresponding to the intersections between the scan lines SL1 through SLn and the data lines DL1 through DLm.

In one example embodiment, the pixels PX are arranged in a stripe shape. When the pixels PX are arranged in the stripe shape, each of the pixels PX can include a red color sub-pixel, a green color sub-pixel, and a blue color sub-pixel. In another example embodiment, the pixels are arranged in a pentile shape. The display panel having the pentile shape structure can reduce the number of the red color sub-pixels and the blue sub color pixels by half in comparison with the display panel having the stripe shape structure. Therefore, the display panel having the pentile shape structure can reduce the number of total pixels by 2/3 in comparison with the display panel having the stripe shape structure, thereby increasing the opening ratio of the display panel 100.

In one example embodiment, a red color OLED included in the red color sub-pixel, a green color OLED included in the green color sub-pixel, and a blue color OLED included in the blue color sub-pixel have different thicknesses from each other. The thicknesses of the red, the green, and the blue color OLEDs can be respectively determined considering a resonance effect to achieve optimal or improved efficiency. In one example embodiment, the blue color OLED can include a first electrode, a second electrode opposing the first electrode, a blue color organic emission layer interposed between the first electrode and the second electrode, and a resonance layer interposed between the first electrode and the second electrode. Also, the resonance layer can have a thickness for the constructive interference of blue color light emitted by the blue color organic emission layer. Since the structure of the OLED is described above, duplicated descriptions thereof will be omitted.

The scan driver 200 provides scan signals to the pixels PX via the scan lines SL1 through SLn.

The data driver 400 provides data signals to the pixels PX via the data lines DL1 through DLm.

The power supply 500 provides a high power voltage ELVDD and a low power voltage ELVSS to the pixels PX via power lines.

The timing controller 600 controls the scan driver 200, the MTP processor 300, the data driver 400, and the power supply 500 based on first through fourth control signals CTLi through CTL4.

The MTP processor 300 adjusts image data using MTP adjustment data for outputting blue color data using the blue color sub-pixel, the green color sub-pixel, and the red color sub-pixel. For example, the MTP processor 300 can convert input image data signal IN_DATA to output image data signal OUT_DATA using the MTP adjustment data. In one example embodiment, the MTP processor 300 is located outside of the data driver 400 and the timing controller 600, as shown in FIG. 11. In another example embodiment, the MTP processor 300 can be located inside of the data driver 400 or the timing controller 600.

In one example embodiment, when the pixels PX are arranged in the stripe shape, the MTP processor 300 adjusts the image data to output the blue color data using a first red color sub-pixel, a first green color sub-pixel, and a first blue color sub-pixel that are included in a first pixel. In another example embodiment, when the pixels PX are arranged in the pentile shape, the MTP processor 300 adjusts the image data to output the blue color data using a second pixel and a third pixel. Here, the second pixel includes a second blue color sub-pixel and a second green color sub-pixel. The third pixel includes a third red color sub-pixel and a third green color sub-pixel. Since a variety of methods of outputting the blue color data using the blue color sub-pixel, the green color sub-pixel, and the red color sub-pixel that are adjacent to each other are described above, duplicated descriptions will be omitted.

As shown in FIG. 12, the MTP processor 300 includes a memory device or memory 320 and an image data adjusting device or image data adjustment unit 340.

The memory device 320 stores the MTP adjustment data that are adjusted by the white color MTP operation and the blue color MTP operation. The MTP adjustment data include information for a compensation gamma curve. Therefore, the MTP adjustment data can be adjusted to output the blue color data using the blue color sub-pixel, the green color sub-pixel, and the red color sub-pixel adjacent to each other. In one example embodiment, the MTP adjustment data can include MTP offset data that are calculated based on a reference gamma curve. For example, the MTP offset data can include red color offset data corresponding to the red color sub-pixel, green color offset data corresponding to the green color sub-pixel, and blue color offset data corresponding to the blue color sub-pixel. The offset data for each pixel can be respectively stored to independently set gamma curves for each pixel, thereby enhancing the display quality. In another example embodiment, the MTP adjustment data can include the compensation gamma curves for each of pixels.

The image data adjusting device 340 can adjust the image data based on the MTP adjustment data stored in the memory device 320. Thus, the image data adjusting device 340 can convert input image data signal IN_DATA to output image data signal OUT_DATA using the MTP adjustment data. Therefore, the blue color light can be emitted using the red color OLED and the green color OLED that have a relatively high light efficiency as well as the blue color OLED of which thickness is formed to have a maximum or increased efficiency.

In addition, the MTP processor 300 can further include an MTP buffer for storing updated MTP adjustment data in the memory device 320.

Although it is illustrated in FIG. 12 that the MTP processor 300 includes the memory device 320 and the image data adjusting device 340, the MTP processor 300 can have various structures in order to output the blue color data using the blue color sub-pixel, the green color sub-pixel, and the red color sub-pixel that are adjacent to each other.

Therefore, the OLED display 1000 can improve a life span of a display panel and reduce power consumption by including the MTP processor 300.

Although the example embodiments describe that a thickness of OLED is adjusted using the resonance layer, the thickness of OLED can be adjusted by a variety of methods.

The described technology may be applied to an electronic device having an OLED display. For example, the described technology can be applied to a cellular phone, a smart phone, a smart pad, a personal digital assistant (PDA), etc.

As discussed, embodiments of the invention can provide a method of performing a multi-time programmable, MTP, operation, the method comprising: performing a white color MTP operation for displaying a first target color coordinate corresponding to a white color test grayscale on a display device so as to generate MTP adjustment data; and performing a blue color MTP operation for displaying a second target color coordinate corresponding to a blue color test grayscale on the display device, wherein the blue color MTP operation comprises adjusting the MTP adjustment data such that the display device displays blue color data using a blue color sub-pixel, a green color sub-pixel adjacent to the blue color sub-pixel, and a red color sub-pixel adjacent to the blue color sub-pixel.

Embodiments of the invention can also provide an organic light-emitting diode, OLED, display, comprising: a display panel including a plurality of pixels, wherein the pixels include a red color sub-pixel, a green color sub-pixel, and a blue color sub-pixel that are adjacent to each other; a scan driver configured to apply scan signals to the pixels; a multi-time programmable, MTP, processor configured to adjust image data using MTP adjustment data, wherein the display panel is configured to display blue color data using the blue color sub-pixel, the green color sub-pixel, and the red color sub-pixel; a data driver configured to: i) generate data signals based on the adjusted image data and ii) apply the data signals to the pixels; a power supply configured to provide a high power voltage and a low power voltage to the pixels; and a timing controller configured to control the scan driver, the MTP processor, the data driver, and the power supply.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages of the inventive technology. Accordingly, all such modifications are intended to be included within the scope of the invention as defined in the claims. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A method of performing a multi-time programmable, MTP, operation, the method comprising:
performing a white color MTP operation for displaying a first target color coordinate corresponding to a white color test grayscale on a display device so as to generate MTP adjustment data; and
performing a blue color MTP operation for displaying a second target color coordinate corresponding to a blue color test grayscale on the display device,
wherein the blue color MTP operation comprises adjusting the MTP adjustment data such that the display device displays blue color data using a blue color sub-pixel, a green color sub-pixel adjacent to the blue color sub-pixel, and a red color sub-pixel adjacent to the blue color sub-pixel.

2. The method of claim 1, wherein the blue, green, and red color sub-pixels are included in the same pixel.

3. The method of claim 1 or 2, wherein the performing of the white color MTP operation includes:
determining the first target color coordinate corresponding to the white color test grayscale;
measuring a first color coordinate for a first image corresponding to the white color test grayscale when the first image is displayed on the display device;
comparing the first target color coordinate to the first measured color coordinate; and
generating the MTP adjustment data such that the first measured color coordinate substantially matches the first target color coordinate.

4. The method of any one of claims 1 to 3, wherein performing the blue color MTP operation includes:
determining the second target color coordinate corresponding to the blue color test grayscale;
measuring a second color coordinate for a second image corresponding to the blue color test grayscale when the second image is displayed on the display device;
comparing the second target color coordinate to the second measured color coordinate; and
adjusting the MTP adjustment data such that the second measured color coordinate substantially matches the second target color coordinate.

5. The method of claim 4, wherein the MTP adjustment data includes MTP offset data that are calculated based on a reference gamma curve.

6. The method of claim 5, wherein the MTP offset data include red color offset data corresponding to the red color sub-pixel, green color offset data corresponding to the green color sub-pixel, and blue color offset data corresponding to the blue color sub-pixel.

7. The method of claim 6, wherein the display device comprises a driving integrated circuit, IC, including a memory and wherein the MTP adjustment data are stored in the memory.

8. An organic light-emitting diode, OLED, display, comprising:
a display panel including a plurality of pixels, wherein the pixels include a red color sub-pixel, a green color sub-pixel, and a blue color sub-pixel that are adjacent to each other;
a scan driver configured to apply scan signals to the pixels;
a multi-time programmable, MTP, processor configured to adjust image data using MTP adjustment data, wherein the display panel is configured to display blue color data using the blue color sub-pixel, the green color sub-pixel, and the red color sub-pixel;
a data driver configured to: i) generate data signals based on the adjusted image data and ii) apply the data signals to the pixels;
a power supply configured to provide a high power voltage and a low power voltage to the pixels; and
a timing controller configured to control the scan driver, the MTP processor, the data driver, and the power supply.

9. The display of claim 8, wherein the MTP processor is further configured to adjust the MTP adjustment data via:
performing a white color MTP operation for displaying a first target color coordinate corresponding to a white color test grayscale on the display panel; and
performing a blue color MTP operation for displaying a second target color coordinate corresponding to a blue color test grayscale on the display panel.

10. The display of claim 9, wherein the MTP processor includes:
a memory configured to store the MTP adjustment data, wherein the MTP processor is further configured to adjust the MTP adjustment data based on the white color MTP operation and the blue color MTP operation; and
an image data adjustment unit configured to adjust the image data based on the MTP adjustment data.

11. The display of any one of claims 8 to 10, wherein the pixels are arranged in a stripe shape, and
wherein the MTP processor is further configured to adjust the image data such that the display panel displays the blue color data using a first red color sub-pixel, a first green color sub-pixel, and a first blue color sub-pixel that are included in a first pixel.

12. The display of any one of claims 8 to 11, wherein the pixels are arranged in a pentile shape,
wherein the MTP processor is further configured to adjust the image data such that the display panel display the blue color data using a second pixel and a third pixel,
wherein the second pixel includes a second blue color sub-pixel and a second green color sub-pixel, and
wherein the third pixel includes a third red color sub-pixel and a third green color sub-pixel.

13. The display of any one of claims 8 to 12, wherein the red, green, and blue color sub-pixels respectively comprise red, green, and blue organic light-emitting diodes (OLEDs) and wherein each of the red, green, and blue OLEDs has a different thickness.

14. The display of claim 13, wherein the blue color OLED comprises:
a first electrode;
a second electrode opposing the first electrode;
a blue color organic emission layer interposed between the first electrode and the second electrode; and
a resonance layer interposed between the first electrode and the second electrode.

15. The display of claim 14, wherein the resonance layer has a thickness such that the blue color light emitted by the blue color organic emission layer constructively interferes.

## Amended claims

### Amended claims in accordance with Rule 137(2) EPC.

1. A method of performing a multi-time programmable, MTP, operation for adjusting a gamma curve, the method comprising:
performing a white color MTP operation for displaying a first target color coordinate corresponding to a white color test grayscale on a display device so as to generate MTP adjustment data for adjusting the gamma curve; and
performing a blue color MTP operation for displaying a second target color coordinate corresponding to a blue color test grayscale on the display device,
wherein the blue color MTP operation comprises adjusting the MTP adjustment data such that the display device displays blue color data using a blue color sub-pixel, a green color sub-pixel adjacent to the blue color sub-pixel, and a red color sub-pixel adjacent to the blue color sub-pixel.

2. The method of claim 1, wherein the blue, green, and red color sub-pixels are included in the same pixel.

3. The method of claim 1 or 2, wherein the performing of the white color MTP operation includes:
determining the first target color coordinate corresponding to the white color test grayscale;
measuring a first color coordinate for a first image corresponding to the white color test grayscale when the first image is displayed on the display device;
comparing the first target color coordinate to the first measured color coordinate; and
generating the MTP adjustment data such that the first measured color coordinate substantially matches the first target color coordinate.

4. The method of any one of claims 1 to 3, wherein performing the blue color MTP operation includes:
determining the second target color coordinate corresponding to the blue color test grayscale;
measuring a second color coordinate for a second image corresponding to the blue color test grayscale when the second image is displayed on the display device;
comparing the second target color coordinate to the second measured color coordinate; and
adjusting the MTP adjustment data such that the second measured color coordinate substantially matches the second target color coordinate.

5. The method of claim 4, wherein the MTP adjustment data includes MTP offset data that are calculated based on a reference gamma curve.

6. The method of claim 5, wherein the MTP offset data include red color offset data corresponding to the red color sub-pixel, green color offset data corresponding to the green color sub-pixel, and blue color offset data corresponding to the blue color sub-pixel.

7. The method of claim 6, wherein the display device comprises a driving integrated circuit, IC, including a memory and wherein the MTP adjustment data are stored in the memory.

8. An organic light-emitting diode, OLED, display, comprising:
a display panel (100) including a plurality of pixels, wherein the pixels include a red color sub-pixel, a green color sub-pixel, and a blue color sub-pixel that are adjacent to each other;
a scan driver (200) configured to apply scan signals to the pixels;
a multi-time programmable, MTP, processor (300) configured to adjust image data using MTP adjustment data for adjusting a gamma curve, wherein the display panel is configured to display blue color data using the blue color sub-pixel, the green color sub-pixel, and the red color sub-pixel;
a data driver (400) configured to: i) generate data signals based on the adjusted image data and ii) apply the data signals to the pixels;
a power supply (500) configured to provide a high power voltage and a low power voltage to the pixels; and
a timing controller (600) configured to control the scan driver, the MTP processor, the data driver, and the power supply.

9. The display of claim 8, wherein the MTP processor is further configured to adjust the MTP adjustment data via:
performing a white color MTP operation for displaying a first target color coordinate corresponding to a white color test grayscale on the display panel; and
performing a blue color MTP operation for displaying a second target color coordinate corresponding to a blue color test grayscale on the display panel.

10. The display of claim 9, wherein the MTP processor includes:
a memory configured to store the MTP adjustment data, wherein the MTP processor is further configured to adjust the MTP adjustment data based on the white color MTP operation and the blue color MTP operation; and
an image data adjustment unit configured to adjust the image data based on the MTP adjustment data.

11. The display of any one of claims 8 to 10, wherein the pixels are arranged in a stripe shape, and
wherein the MTP processor is further configured to adjust the image data such that the display panel displays the blue color data using a first red color sub-pixel, a first green color sub-pixel, and a first blue color sub-pixel that are included in a first pixel.

12. The display of any one of claims 8 to 11, wherein the pixels are arranged in a pentile shape,
wherein the MTP processor is further configured to adjust the image data such that the display panel display the blue color data using a second pixel and a third pixel,
wherein the second pixel includes a second blue color sub-pixel and a second green color sub-pixel, and
wherein the third pixel includes a third red color sub-pixel and a third green color sub-pixel.

13. The display of any one of claims 8 to 12, wherein the red, green, and blue color sub-pixels respectively comprise red, green, and blue organic light-emitting diodes (OLEDs) and wherein each of the red, green, and blue OLEDs has a different thickness.

14. The display of claim 13, wherein the blue color OLED comprises:
a first electrode;
a second electrode opposing the first electrode;
a blue color organic emission layer interposed between the first electrode and the second electrode; and
a resonance layer interposed between the first electrode and the second electrode.

15. The display of claim 14, wherein the resonance layer has a thickness such that the blue color light emitted by the blue color organic emission layer constructively interferes.
